# EUROPÄISCHE PATENTSCHRIFT

(11) **EP 0 400 397 B1**
(45) Veröffentlichungstag und Bekanntmachung des Hinweises auf die Patenterteilung: **12.04.1995**
(21) Anmeldenummer: 90109250.2
(22) Anmeldetag: 16.05.1990
(51) Int. Cl.: H03L 7/07, H04J 3/06

(54) **Verfahren zur Synchronisation eines mit Hilfe eines Zählers erzeugten Taktes auf einen Referenztakt**
Synchronisation method of a counter generated clock on a reference clock
Procédé de synchronisation d'une horloge engendré à l'aide d'un compteur sur une horloge de référence

(30) Priorität: 31.05.1989 DE 3917712
(43) Veröffentlichungstag der Anmeldung: 05.12.1990
(73) Patentinhaber: SIEMENS AKTIENGESELLSCHAFT, 80333 München (DE)
(72) Erfinder: Ernst, Wolfgang, Dipl.-Ing., D-8000 München 70 (DE); Uhlig, Gerhard, Dipl. Phys., D-8000 München 90 (DE)

(56) Entgegenhaltungen:
- EP-A- 0 129 098
- EP-A- 0 228 685
- US-A- 4 282 493

## Beschreibung

Die Erfindung betrifft ein Verfahren zur Synchronisation eines mit Hilfe eines Zählers erzeugten Taktes auf einen Referenztakt, der über eine Referenzleitung zugeführt wird.

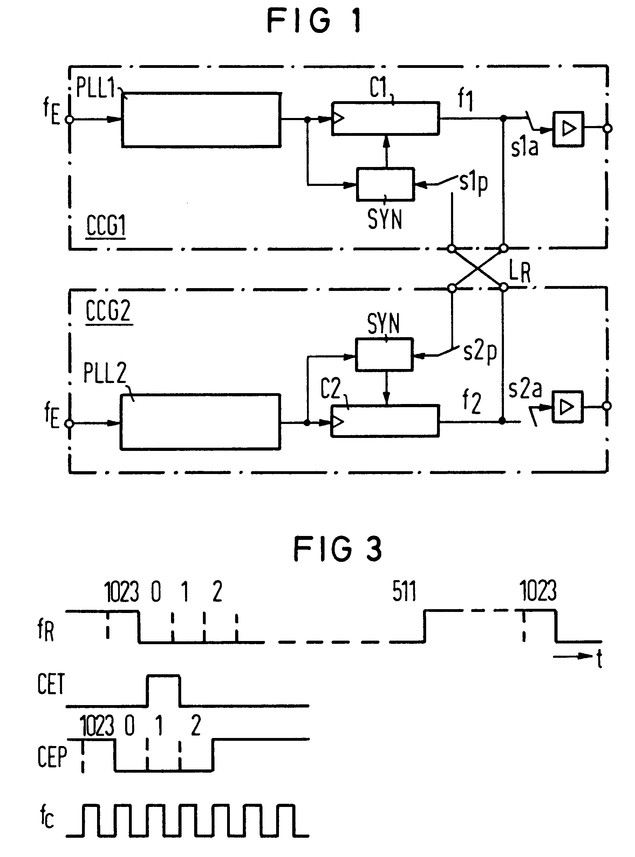

FIG 1 zeigt einen speziellen Anwendungsfall einer Synchronisierschaltung SYN in einer zentralen Taktversorgung einer Fernmeldevermittlungsstelle, die nach dem Master/Slave-Prinzip von einer externen Referenzfrequenz f_{E} synchronisiert wird. Die zentrale Taktversorgung besteht aus einem ersten zentralen Taktgenerator CCG1 und einem zweiten zentralen Taktgenerator CCG2, wobei im Normalbetrieb der zentralen Taktversorgung der erste zentrale Taktgenerator CCG1 aus dem externen Referenztakt f_{E} über einen ersten Phasenregelkreis PLL1 und einen ersten Zähler C1 einen ersten Takt f₁ erzeugt, der über einen Schalter s1a an den Ausgang der Taktversorgung durchgeschaltet ist und als Amtstakt die Vermittlungsstelle synchronisiert.

Der zweite zentrale Taktgenerator bildet währenddessen ebenso über einen zweiten Phasenregelkreis PLL2 und einen zweiten Zähler C2 einen zweiten Takt f₂ gleicher Frequenz, der jedoch nur im Ersatzfall (bei Ausfall des ersten zentralen Taktgenerators oder zu routinemäßigen Prüfzwecken) über einen zweiten Schalter s2a als Amtstakt an den Ausgang der zentralen Taktversorgung durchgeschaltet ist.

Ist also der Schalter s1a geschlossen, so ist der Schalter s2a geöffnet und umgekehrt. Dasselbe Verhältnis zueinander besitzen ein Schalter s1p und ein Schalter s2p. Im Normalbetrieb der zentralen Taktversorgung ist der Schalter s2p geschlossen und der Schalter s1p geöffnet, während bei einem Wechsel des normalerweise aktiven ersten zentralen Taktgenerators im Ersatzfall der Schalter s2p geöffnet und der Schalter s1p geschlossen ist.

Da im Ersatzfall der erste Takt f₁ durch den zweiten Takt f₂ als Amtstakt ersetzt wird, ist es zur Vermeidung eines Phasensprungs erforderlich, daß der zweite Takt zu jeder Zeit auch hinsichtlich der Phasenlage mit dem ersten Takt, der hier den Referenztakt darstellt, übereinstimmt.

Es ist z.B. aus Dokument EP-A2 0 228 685 bekannt, die genannte Forderung mit Hilfe einer Synchronisierschaltung SYN zu erfüllen, die beispielsweise jede fallende Flanke des Referenztaktes registriert und mit der jeweils darauffolgenden steigenden Flanke eines Zähltaktes einen Zähler zurücksetzt, wodurch der von diesem Zähler erzeugte Takt ständig auf den Referenztakt synchronisiert wird. Die Versorgung der Synchronisierschaltung mit dem Referenztakt erfolgt dabei über eine Referenzleitung L_{R}.

Treten auf der Referenzleitung Impulse auf, die z.B. bei einem plötzlichen Ausfall des Referenztaktes oder aufgrund unerwünschter Überkopplungen auf die Referenzleitung entstehen können, so führen deren fallende Flanken ebenfalls zu einer Synchronisation und bewirken in dem speziellen Beispiel nach Figur 1 bei einem darauffolgenden Wechsel des aktiven zentralen Taktgenerators einen bleibenden irreversiblen Phasensprung des Amtstaktes.

Der Erfindung liegt die Aufgabe zugrunde, eine fehlerfreie Synchronisation eines Taktes auf einen Referenztakt zu gewährleisten.

Diese Aufgabe wird bei einem gattungsgemäßen Verfahren durch die kennzeichnenden Merkmale des Anspruchs 1 gelöst.

Es wird also erreicht, daß in der Regel nur solche Flanken des Referenztaktes, die innerhalb eines vorgegebenen kleinen Zeitbereichs liegen, zur Synchronisation des Taktes führen.

Um das erfindungsgemäße Verfahren durchzuführen, ist eine Anordnung nach Anspruch 2 vorgeschlagen.

Nach einer Ausgestaltung der Anordnung nach Anspruch 3 ermöglicht es eine retriggerbare monostabile Kippstufe in besonders einfacher Weise eine unerlaubte Synchronisation bei Ausfall des Referenztaktes zu verhindern.

Nach einer weiteren Ausgestaltung der Anordnung nach Anspruch 4 wird durch einen Vergleicher in ebenfalls besonders einfacher Weise ein Zeitfenster bezüglich des Taktes festgelegt.

Eine weitere Ausgestaltung der Anordnung nach Anspruch 5 dient der geeigneten schaltungsmäßigen Umsetzung der Forderung, daß eine Synchronisation in der Regel nur dann stattfinden darf, wenn eine bestimmte Flanke des Referenztaktes innerhalb eines bestimmten periodisch wiederkehrenden Zeitbereichs liegt.

Es folgt eine Liste von den Figuren der Zeichnung:
- FIG 1: zeigt eine zentrale Taktversorgung einer Fernmeldevermittlungsstelle, bei der die Erfindung angewendet werden kann.
- FIG 2: zeigt den Aufbau einer Schaltungsanordnung zur Durchführung des erfindungsgemäßen Verfahrens.
- FIG 3: zeigt ein Zeitdiagramm zur Erläuterung der Betriebsweise der Schaltungsanordnung gemäß FIG 2.

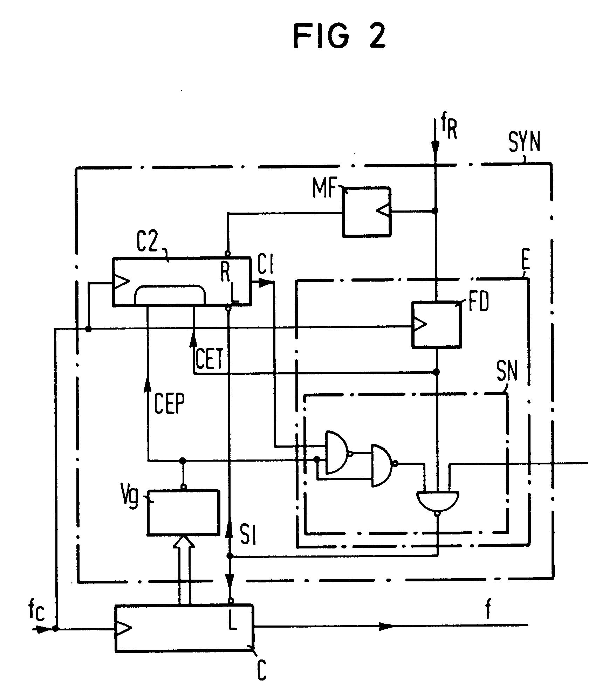

Nachstehend wird ein spezielles Ausführungsbeispiel zur Realisierung des erfindungsgemäßen Verfahrens anhand der FIG 2 und FIG 3 näher erläutert.

Eine Schaltungsanordnung SYN zur Synchronisation eines Taktes f auf einen Referenztakt f_{R} mit Hilfe eines Zählers C besteht aus einem Vergleicher Vg, einer Einrichtung E, einem zweiten Zähler C2 und einer retriggerbaren monostabilen Kippstufe MF.

Der Vergleicher Vg erhält unmittelbar den Stand des Zählers C, den er mit den Werten seiner internen Wertemenge (0, 1, 2) vergleicht. Sein Ausgang liegt genau dann auf Null, wenn der Stand des Zählers C die Werte 0, 1 oder 2 beträgt. Auf diese Weise erzeugt er mit seinem Ausgang ein Fenstersignal CEP, das bezüglich des Taktes f ein durch die Werte 0, 1, 2 festgelegtes Zeitfenster ZF erzeugt. Das Realisieren eines derartigen Zeitfensters wäre auch in etwas aufwendigerer Weise mit einem Synchronzähler in Verbindung mit einer kleinen Logik realisierbar.

Die Größe des Zeitfensters ZF richtet sich danach, wieweit der Takt f normalerweise ohne die erfindungsgemäße Synchronisierschaltung SYN in einer Periode 1/f von dem Referenztakt wegtriftet, d.h. wieweit sich die bestimmten Flanken der beiden Takte gegeneinander verschieben.

Die Einrichtung E erzeugt einen Synchronisierimpuls SI, der zum einen durch ein Neuladen L des Zählers C die Synchronisation des Taktes auf den Referenztakt f_{R} bewirkt und zum anderen gleichzeitig das Neuladen L des zweiten Zählers C2. Der Zeitpunkt des Neuladens ist durch die aufsteigende Flanke eines Zähltaktes f_{c} bestimmt.

Die Einrichtung E besteht aus einem Flankendetektor FD und einer kombinatorischen Logik in Form eines Schaltnetzes SN. Der Flankendetektor erzeugt aus jeder fallenden Flanke des Referenztaktes mit der nächstfolgenden aufsteigenden Flanke des Zähltaktes f_{C} einen Impuls eines Zählerfreigabesignals CET, der die Periodenlänge des Zähltaktes f_{c} aufweist. Der Ausgang des Schaltnetzes, der den Synchronisierimpuls liefert, liegt genau dann auf logisch 0, wenn entweder das Zählerfreigabesignal CET auf logisch 1 und das Fenstersignal CEP auf logisch 0 liegt, oder ein Übertragssignal CI, das von dem zweiten Zähler stammt, auf logisch 1 und das Fenstersignal GEP auf logisch 1 liegt. Der Synchronisierimpuls mit der Länge einer Periode des Zähltaktes wird also außer durch das Übertragungssignal CI nur dann erzeugt, wenn die negative Flanke des Referenztaktes f_{R} in denjenigen Zeitbereich fällt, der durch die Zählerstände 1023 (höchster Zählerstand), 0, und 1 des Zählers C gekennzeichnet ist, der also zeitlich um einen Zähltakt vor dem gleichlangen Zeitfenster ZF liegt.

Der zweite Zähler C2 zählt diejenigen Impulse des Zählerfreigabesignals CET, die außerhalb des durch das Fenstersignal festgelegten Zeitfensters ZF liegen, und erzeugt bei Erreichen seines Höchststandes das Übertragssignal CI, welches über das Schaltnetz SN zur Auslösung eines Synchronisierimpulses führt.

Dadurch wird es ermöglicht, das eine Synchronisation ausnahmsweise auch außerhalb des Zeitfensters ZF stattfinden kann. Dies ist zum einen bei Inbetriebnahme des Zählers (bzw. des Systems, in das der Zähler integriert ist) nötig und zum anderen bei fehlerbedingten Zählersprüngen.

In beiden genannten Fällen wird sich der durch das Zählerfreigabesignal CET gebildete Puls in der Regel außerhalb des Zeitfensters befinden und eine Synchronisation kann somit erst nach dem Hochzählen des zweiten Zählers C2 stattfinden.

Einzelne Impulse des Zählerfreigabesignals, die außerhalb des Zeitfensters liegen, führen also nicht zur Auslösung eines Synchronisierimpulses SI, während bei einem anstehenden Puls des Zählerfreigabesignals, der außerhalb des Zeitfensters liegt nach einer bestimmten Zeit ein Synchronisierimpuls ausgelöst wird.

Die retriggerbare monostabile Kippstufe MF hat eine Zeitkonstante, die etwas größer als die Periodendauer des Referenztaktes ist. Dadurch bleibt ihr Ausgang bei Anliegen des Referenztaktes ständig auf logisch 1 gesetzt. Bei Ausfall des Referenztaktes fällt sie in ihren stabilen Zustand zurück und bewirkt nach jeder Periode des Zähltaktes f_{C} ein Rücksetzen R des zweiten Zählers C2. So wird verhindert, daß der zweite Zähler durch negative Flanken von einzelnen Impulsen, die dennoch auf der Referenzleitung L_{R} zur Zuführung des Referenztaktes auftreten (z.B. durch Überkopplung), allmählich seinen Höchststand erreicht und dadurch fälschlicherweise eine Synchronisation bewirken könnte. Die Funktion der retriggerbaren monostabilen Kippstufe in dem speziellen Ausführungsbeispiel in FIG 2 kann natürlich auch in etwas aufwendigerer Weise durch einen Mikroprozessor der über eine Überwachung von dem Ausfall des Referenztaktes Bescheid erhält, durchgeführt werden. Der Mikroprozessor kann die Synchronisierschaltung dann bei Ausfall des Referenztaktes beispielsweise mit Hilfe eines Signals SL sperren, das er zu diesem Zweck auf Null setzt.

## Patentansprüche

1. Verfahren zur Synchronisation eines mit Hilfe eines Zählers (C) erzeugten Taktes (f) auf einen Referenztakt (f_{R}), der über eine Referenzleitung (L_{R}) zugeführt wird,
**gekennzeichnet**
durch folgende Merkmale:
a) Eine bestimmte Flanke des Referenztaktes, die innerhalb eines bezüglich des Taktes (f) festgelegten Zeitbereichs auftritt, führt unmittelbar zur Synchronisation des Taktes auf den Referenztakt.
b) Die bestimmten Flanken des Referenztaktes, die außerhalb des Zeitbereichs liegen, werden von einem zweiten Zähler (C2) gezählt und führen erst dann zu einer Synchronisation, wenn sie in genügender Anzahl nach einer erfolgten Synchronisation oder in genügender Anzahl nach der Inbetriebnahme des Zweiten Zählen, aufgetreten sind.
c) Bei Ausfall des Referenztaktes dennoch auf der Referenzleitung auftretende Impulse mit solchen bestimmten Flanken, die außerhalb des Zeitbereichs liegen, werden von dem zweiten Zähler (C2) nicht gezählt und führen daher unter keinen Umständen zu einer Synchronisation.

2. Anordnung zur Durchführung des Verfahrens nach Anspruch 1,
**gekennzeichnet**
durch folgende Merkmale:
a) Es ist eine erste Einrichtung vorhanden, durch die in Form eines Fenstersignals (CEP) bezüglich des Taktes (f) ein Zeitfenster (ZF) bestimmter Lage und Größe festgelegt wird.
b) Es ist eine zweite Einrichtung vorhanden, durch die eine Synchronisation des Taktes bewirkt wird, wenn eine bestimmte Flanke des Referenztaktes innerhalb eines durch das Fenstersignal festgelegten Zeitbereichs liegt.
c) Es ist ein zweiter Zähler (C2) vorhanden, der
c1) jede der bestimmten Flanken des Referenztaktes zählt, die außerhalb des Zeitbereichs liegen,
c2) bei jeder Synchronisation erneut mit einem bestimmten Wert geladen wird,
c3) bei Erreichen seines Höchststandes ein Übertragungssignal (CI) erzeugt, das außerhalb des Zeitbereiches zum Auslösen einer Synchronisation führt.
d) Es ist eine dritte Einrichtung vorhanden, durch die eine unerlaubte Synchronisation des Taktes verhindert wird, wenn der Referenztakt ausfällt.

3. Anordnung nach Patentanspruch 3,
**dadurch gekennzeichnet**,
daß die dritte Einrichtung aus einer retriggerbaren monostabilen Kippstufe (MF) besteht, wobei
a) der Referenztakt auf den Takteingang der retriggerbaren monostabilen Kippstufe wirkt,
b) das Ausgangssignal der retriggerbaren monostabilen Kippstufe auf den Rücksetzeingang des zweiten Zählers (C2) wirkt.

4. Anordnung nach Patentanspruch 2 oder 3,
**dadurch gekennzeichnet,**
daß die erste Einrichtung ein Vergleicher (Vg) ist, der vergleicht, ob der momentane Stand des Zählers (C) einem Wert entspricht, der innerhalb eines vorgegebenen Wertebereichs liegt und dadurch an seinem Ausgang ein Fenstersignal bildet, das bezüglich des Taktes (f) ein durch den genannten Wertebereich festgelegtes Zeitfenster (ZF) erzeugt.

5. Anordnung nach Anspruch 2 bis 4,
**dadurch gekennzeichnet**,
daß die zweite Einrichtung aus einem Flankendetektor (FD) und einem Schaltnetz (SN) besteht, wobei
a) der Flankendetektor aus einer bestimmten Flanke des Referenztaktes einen Freigabeimpuls (CET) bestimmter Länge erzeugt,
b) das Schaltnetz dann einen Synchronimpuls (SI) erzeugt, wenn entweder der Freigabeimpuls (CET) im Zeitfenster des Fenstersignals liegt oder der Freigabeimpuls (CET) außerhalb des Zählfensters liegt und der zweite Zähler seinen Höchststand erreicht hat.

## Claims

1. Method for synchronizing a clock pulse (f), generated by means of a counter (C), to a reference clock pulse (f_{R}) which is supplied via a reference line (L_{R}), characterized by the following features:
a) A specific edge of the reference clock pulse which occurs within a time range fixed with reference to the clock pulse (f) leads directly to synchronization of the clock pulse to the reference clock pulse.
b) The specific edges of the reference clock pulse, which are situated outside the time range, are counted by a second counter (C2) and do not lead to synchronization until they have occurred in sufficient number after a performed synchronization or in sufficient number after the second counter has been started up.
c) In the event of failure of the reference clock pulse, pulses nevertheless occurring on the reference line with such specific edges which are situated outside the time range are not counted by the second counter (C2) and therefore under no circumstances lead to synchronization.

2. Arrangement for carrying out the method according to Claim 1, characterized by the following features:
a) A first device is present by means of which a time window (ZF) of specific position and size is fixed in the form of a window signal (CEP) with respect to the clock pulse (f).
b) A second device is present by means of which synchronization of the clock pulse is effected when a specific edge of the reference clock pulse is situated inside a time range fixed by the window signal.
c) A second counter (C2) is present which
c1) counts each of the specific edges of the reference clock pulse which are situated outside the time range,
c2) is recharged with a specific value in the case of each synchronization,
c3) upon reaching its maximum reading generates a transmission signal (CI) which leads outside the time range to the triggering of synchronization.
d) A third device is present by means of which an impermissible synchronization of the clock pulse is prevented when the reference clock pulse fails.

3. Arrangement according to Patent Claim 3, characterized in that the third device comprises a retriggerable monostable multivibrator (MF), it being the case that
a) the reference clock pulse acts on the clock input of the retriggerable monostable multivibrator,
b) the output signal of the retriggerable monostable multivibrator acts on the resetting input of the second counter (C2).

4. Arrangement according to Patent Claim 2 or 3, characterized in that the first device is a comparator (Vg) which compares whether the instantaneous reading of the counter (C) corresponds to a value which is situated within a prescribed range of values and thereby forms at its output a window signal which generates with respect to the clock pulse (f) a time window (ZF) fixed by means of the said range of values.

5. Arrangement according to Claims 2 to 4, characterized in that the second device comprises an edge detector (FD) and a combinational circuit (SN), it being the case that
a) the edge detector generates an enable pulse (CET) of specific length from a specific edge of the reference clock pulse,
b) the combinational circuit generates a synchronization pulse (SI) whenever either the enable pulse (CET) is situated in the time window of the window signal, or the enable pulse (CET) is situated outside the time window and the second counter has reached its maximum reading.

## Revendications

1. Procédé pour synchroniser une cadence (f), produite à l'aide d'un compteur (C), sur une cadence de référence (f_{R}), qui est envoyée par l'intermédiaire d'une ligne de référence (L_{R}), caractérisé par les particularités suivantes :
a) un flanc déterminé de la cadence de référence, qui apparaît pendant une plage temporelle fixée par rapport à la cadence (f), conduit directement à la synchronisation sur la cadence de référence;
b) les flancs déterminés de la cadence de référence, qui sont situés à l'extérieur de la plage temporelle, sont comptés par un second compteur (C2) et conduisent à une synchronisation uniquement lorsqu'ils sont apparus en un nombre suffisant après une synchronisation effectuée ou en un nombre suffisant après la mise en service du second compteur;
c) mais lors de la défaillance de la cadence de référence, des impulsions, qui apparaissent dans la ligne de référence et possèdent des flancs déterminés qui sont situés à l'extérieur de la plage temporelle, ne sont pas comptées par le second compteur (C2) et ne conduisent par conséquent en aucun cas à une synchronisation.

2. Dispositif pour la mise en oeuvre du procédé suivant la revendication 1, caractérisé par les particularités suivantes :
a) il est prévu un premier dispositif, grâce auquel une fenêtre temporelle (ZF) possédant une position et une taille déterminées est fixée sous la forme d'un signal de fenêtre (CEP) par rapport à la cadence (f);
b) il est prévu un second dispositif, qui réalise une synchronisation de la cadence lorsqu'un flanc déterminé de la cadence de référence se situe à l'intérieur d'une plage temporelle fixée par le signal de fenêtre;
c) il est prévu un second-compteur (C2) qui
c1) compte chacun des flancs déterminés de la cadence de référence, qui sont situés à l'extérieur de la plage temporelle,
c2) est chargé à nouveau par une valeur déterminée lors de chaque synchronisation,
c3) produit, lorsque son état maximum est atteint, un signal de transmission (CI), qui conduit au déclenchement d'une synchronisation en dehors de la plage temporelle; et
d) il est prévu un troisième dispositif, qui empêche une synchronisation non autorisée de la cadence, lorsque la cadence de référence est défaillante.

3. Dispositif suivant la revendication 3, caractérisé par le fait que le troisième dispositif est constitué par un étage à bascule monostable redéclenchable (MF),
a) la cadence de référence agissant sur l'entrée de cadence de l'étage à bascule monostable redéclenchable; et
b) le signal de sortie de l'étage à bascule monostable redéclenchable agissant sur l'entrée de remise à zéro du second compteur (C2).

4. Dispositif suivant la revendication 2 ou 3, caractérisé par le fait que le premier dispositif est un comparateur (Vg) qui vérifie si l'état instantané du compteur (C) correspond à une valeur qui est située dans une plage temporelle prédéterminée et forme de ce fait à sa sortie un signal de fenêtre qui, par rapport à la cadence (f), produit une fenêtre temporelle (ZF) fixée par ladite gamme de valeurs.

5. Dispositif suivant les revendications 2 à 4, caractérisé par le fait que le second dispositif est constitué par un détecteur de flancs (FD) et par un réseau commuté (SN),
a) le détecteur de flancs produisant, à partir d'un flanc déterminé de la cadence de référence, une impulsion de libération (CET) ayant une longueur déterminée, et
b) le réseau commuté produisant une impulsion de synchronisation (SI) lorsque soit l'impulsion de libération (CET) est située dans la fenêtre temporelle du signal de fenêtre, soit est située à l'extérieur de la fenêtre de comptage et que le second compteur a atteint son état maximum.
